# FASCICULE DE BREVET EUROPEEN

(11) **EP 1 650 806 B1**
(45) Date de publication et mention de la délivrance du brevet: **12.05.2010**
(21) Numéro de dépôt: 05292134.3
(22) Date de dépôt: 12.10.2005
(51) Int. Cl.: H01L 27/11, G11C 14/00, G11C 17/12

(54) **Cellule de mémoire volatile préenregistrée.**
Vorbespielte flüchtige Speicherzelle
Pre-recorded volatile memory cell

(30) Priorité: 25.10.2004 FR 0411360
(43) Date de publication de la demande: 26.04.2006
(73) Titulaire: STMICROELECTRONICS SA, 92120 Montrouge (FR)
(72) Inventeur: Candelier, Philippe, 38190 Saint Mury Monteymond (FR); Lasseuguette, Jean, 38000 Grenoble (FR); Fournel, Richard, 38660 Lumbin (FR)
(74) Mandataire: Verdure, Stéphane

(56) Documents cités:
- EP-A- 0 460 691
- PATENT ABSTRACTS OF JAPAN vol. 012, no. 318 (E-650), 29 août 1988 (1988-08-29) & JP 63 081974 A (HITACHI LTD), 12 avril 1988 (1988-04-12)
- JAN M. RABAEY: "Digital integrated circuits: a design perspective" 1996, PRENTICE HALL ELECTRONICS AND VLSI SERIES , XP002366019 * page 126 - page 127 *

## Description

L'invention se rapporte aux mémoires statiques à accès aléatoire (SRAM) réalisées en technologie MOS et pour lesquelles une valeur d'initialisation est préenregistrée.

Comme il est connu de l'homme du métier, les mémoires SRAM utilisent généralement des cellules comportant deux inverseurs montés tête-bêche pour mémoriser un bit de données. Lors de la mise sous tension d'une telle cellule de mémoire SRAM, la cellule se positionne aléatoirement soit la valeur 0, soit la valeur 1. Pour utiliser ces cellules de mémoire SRAM, il est nécessaire d'effectuer une écriture de donnée préalablement à la lecture de cette donnée. De même, lorsqu'il y a une coupure d'alimentation, toute donnée stockée dans la mémoire est perdue de manière définitive.

Si l'on désire mémoriser de manière non volatile un programme sur un circuit à mémoire, il est nécessaire de disposer de cellules de mémoires de type à lecture seule (ROM), ou ROM programmable, ou encore ROM reprogrammable en plus d'une mémoire à accès aléatoire. En effet, une mémoire ROM classique n'étant pas inscriptible, celle-ci ne peut pas être utilisée pour stocker des variables d'un programme. Pour les mémoires de type ROM programmable ou reprogrammable, les temps d'accès sont plus longs que pour les mémoires de type RAM et pénalisent leur utilisation en terme de vitesse d'utilisation.

Une autre utilisation de mémoire non volatile sert à mémoriser dans des circuits des informations spécifiques, notamment d'identification. Dans le cas d'un numéro de série de circuit qui est commun à de nombreux circuits, il est possible d'utiliser des cellules de mémoire de type ROM. Par contre, lorsque l'on désire avoir des circuits identifiés individuellement, par exemple des circuits de téléphones portables, de cartes SIM ou de cartes bancaires, il est nécessaire d'avoir recours à des mémoires de type ROM programmable. Ces mémoires de type ROM programmable sont programmées avec le numéro d'identification propre au circuit en sortie de chaîne de fabrication. Un inconvénient de ce type d'utilisation de ROM programmable d'un point de vue de la sécurité est que des personnes malintentionnées peuvent très bien se procurer des circuits non programmés, ou peuvent reprogrammer des circuits reprogrammables à des fins frauduleuses.

La demande EP-A-1 434 237 dévoile une cellule de mémoire SRAM non volatile qui comporte des moyens pour mémoriser une donnée de manière indélébile. Une telle cellule de mémoire peut être programmée une fois de manière indélébile en provoquant une dégradation irréversible des couches d'oxyde de grille d'une partie au moins des transistors. Malgré cette programmation, il est possible d'utiliser cette mémoire comme une mémoire RAM classique, la donnée mémorisée de manière indélébile pouvant être lue lors de la mise sous tension de la mémoire. Ceci permet d'avoir une mémoire volatile à accès rapide tout en ayant une capacité de mémoire non volatile. Toutefois, cette cellule manque de fiabilité à long terme. En effet, l'usure globale de tous les transistors de la cellule réduit l'effet produit par l'usure prématurée d'une partie de transistors. Si cette cellule est fortement sollicitée en lecture et en écriture, l'usure globale de la cellule tend à effacer le contenu de la cellule de mémoire. Ainsi, l'information n'a pas une bonne fiabilité dans le temps pour certaines applications intensives. De plus, cette cellule de mémoire nécessite des transistors supplémentaires, et cette mémoire reste programmable en sortie de chaîne de fabrication.

L'invention a pour objet de proposer une cellule de mémoire SRAM capable de mémoriser une donnée de manière non volatile. La mémorisation de la donnée se fait à l'aide d'une différence de dopage sur au moins l'un des transistors de la cellule. Ainsi, le pré-enregistrement de la cellule ou des cellules d'un circuit qui comporte plusieurs cellules se fait lors d'une phase technologique de fabrication, et non par programmation en fin de chaîne.

Le document JP-A-63 081974 divulgue une cellule mémoire de ce type, dans laquelle le transistor PMOS d'un des deux inverseurs CMOS de la cellule est un transistor déplété. Par rapport à l'art antérieur conforme à ce document, l'invention permet d'atteindre ce résultat même pour des faibles tension d'alimentation.

Un premier aspect de l'invention est une cellule de mémoire selon la revendication 1.

Un deuxième aspect de l'invention est un circuit intégré selon la revendication3.

Préférentiellement, le circuit intégré comporte des moyens de commande pour mettre sous tension ou hors tension le circuit d'alimentation qui alimente lesdites cellules, ledit circuit de commande étant apte à mettre le circuit d'alimentation sous tension uniquement pour lire le contenu desdites cellules.

Encore un autre aspect de l'invention est un circuit de mémoire électronique selon la revendication 6.

L'invention sera mieux comprise et d'autres particularités et avantages apparaîtront à la lecture de la description qui va suivre en faisant référence aux figures annexées parmi lesquelles
la figure 1 représente un exemple de cellule de mémoire selon l'invention,
la figure 2 représente des courbes de fonctionnement d'un exemple qui n'est pas selon l'invention
la figure 3 représente des courbes de fonctionnement selon un mode de réalisation.

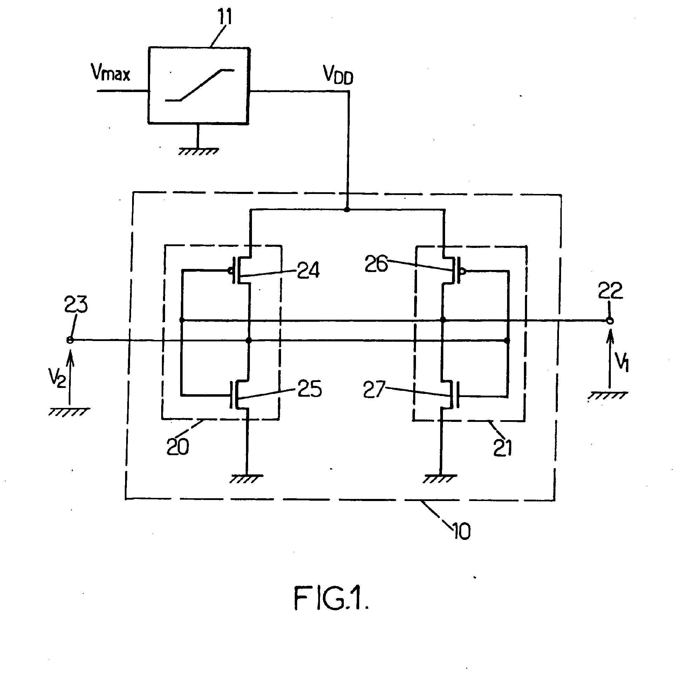

La figure 1 représente une cellule de mémoire 10 de type SRAM. Cette cellule de mémoire 10 est alimentée par un circuit d'alimentation 11. Le circuit d'alimentation 11 sert à réaliser une montée sous tension progressive de la tension d'alimentation V_{DD} de la cellule.

La cellule de mémoire 10 comporte deux inverseurs 20 et 21 montés tête-bêche, c'est-à-dire que chaque inverseur a sa sortie connectée à l'entrée de l'autre inverseur. La sortie de l'inverseur 21 correspond à une borne de sortie 22 de la cellule de mémoire 10, où l'on peut lire une tension V1. La sortie de l'inverseur 20 correspond à une borne de sortie 23 de la cellule de mémoire 10 ou l'on peut lire une tension V2. Dans un mode de réalisation, l'inverseur 20 comporte un transistor PMOS 24 et un transistor NMOS 25. Les drains des transistors 24 et 25 sont connectés ensemble pour former la sortie de l'inverseur 20. Les grilles des transistors 24 et 25 sont connectées ensemble pour former l'entrée de l'inverseur 20 qui est reliée à la sortie de l'inverseur 21. La source du transistor 25 est reliée à la masse tandis que la source du transistor 24 reçoit la tension d'alimentation V_{DD} de la cellule de mémoire 10. L'inverseur 21 comporte un transistor PMOS 26 et un transistor NMOS 27. Les drains des transistors 26 et 27 sont reliés ensembles et forment la sortie de l'inverseur 21. Les grilles de transistors 26 et 27 sont reliées ensembles et forment la sortie de l'inverseur 21. Les grilles de transistors 26 et 27 sont reliées ensembles et forment l'entrée de l'inverseur 21 qui est reliée à la sortie de l'inverseur 20. La source du transistor 27 est reliée à la masse tandis que la source du transistor 26 reçoit la tension d'alimentation de la cellule de mémoire 10.

Les bornes de sorties des inverseurs 22 et 23 sont reliées suivant le type d'application soit directement à des amplificateurs de lecture soit à des lignes de bits par l'intermédiaire de transistors de liaison, une ligne de bits étant commune à une pluralité de cellule de mémoire. Les lignes de bits sont par ailleurs reliées d'une part à des amplificateurs de lecture, et d'autre part à des amplificateurs d'écriture.

De manière connue, lorsque la tension d'entrée d'un inverseur est à un niveau bas, le transistor PMOS conduit et tire la sortie à un niveau haut. Réciproquement, lorsque la tension d'entrée est à un niveau haut, le transistor NMOS conduit et tire la tension de sortie à un niveau bas. En mode transitoire, la tension d'entrée passe d'un niveau haut à un niveau bas ou passe d'un niveau bas à un niveau haut. Lors de cette transition, la sortie de l'inverseur va basculer lorsque la tension aura atteint une tension de seuil de l'inverseur. La tension de seuil de l'inverseur correspond à une moyenne des tensions de seuil intrinsèques des deux transistors formant l'inverseur. De manière classique, les tensions de seuils de chaque transistor sont à peu près les mêmes en valeur absolue et la tension de seuil de l'inverseur correspond à environ la moitié de la tension d'alimentation.

Lors de l'établissement de la tension d'alimentation, la tension d'alimentation présente elle-même une transition. Les tensions d'entrée des inverseurs sont déterminées par le rapport des capacités des grilles des transistors des inverseurs, ce qui correspond classiquement à environ la moitié de la tension d'alimentation. Lorsque cette tension d'alimentation dépasse le double d'une tension de seuil de conduction du transistor NMOS qui est généralement inférieure en valeur absolue à la tension de seuil du transistor PMOS, l'inverseur se met à basculer de manière franche et sa sortie se trouve positionnée à un état bas.

Dans le cas d'une cellule de mémoire conventionnelle qui comporte deux inverseurs sensiblement identiques, les tensions d'entrée des deux inverseurs correspondent à la moitié de la tension d'alimentation tant que l'un des inverseurs n'a pas basculé. Et le positionnement de la cellule de mémoire se fait lorsque le premier des deux inverseurs se met à basculer pour imprimer un niveau bas sur sa sortie, ce qui automatiquement provoque le basculement de l'autre inverseur à un niveau haut. Cependant, la détermination de l'inverseur qui bascule en premier est très aléatoire, car elle dépend de différences infimes liées à la fabrication ou de phénomènes parasites.

Le principe mis en oeuvre dans l'invention consiste à avoir, dans une cellule donnée, deux inverseurs asymétriques afin que leurs tensions de seuil soient différentes. L'asymétrie est obtenue en réalisant une étape de fabrication supplémentaire sur un seul des transistors de la cellule. Ainsi, l'un des transistors va être déplété au niveau de son canal de conduction. Selon un mode de réalisation particulier, un circuit d'alimentation 11 réalise une pente douce sur la croissance de la tension d'alimentation lors de la mise sous tension afin d'assurer un basculement lent des deux cellules. En effet, si la tension varie trop brusquement, le phénomène est plus difficilement contrôlable. Cependant, s'il s'agit d'une mémoire de grande taille, c'est-à-dire comportant un très grand nombre de cellule de mémoire, la capacité équivalente correspondant à la matrice de cellules peut suffire pour provoquer une croissance en douceur de la tension d'alimentation lors de la mise sous tension et le circuit 11 n'est pas nécessaire.

Plusieurs possibilités de fabrication sont offertes suivant la destination de ce type de cellules. Dans le cas d'une mémoire de type RAM statique pour laquelle on souhaite avoir une remise à zéro de toutes les cellules de mémoire, ou pour laquelle on souhaite imprimer de manière globale un programme préenregistré ou un numéro de série commun à un grand nombre de mémoire, il est possible de réaliser un masque de fabrication pour « sur-doper » l'un des transistors par rapport à l'autre. Ainsi, l'un des transistors, par exemple le transistor 24 va subir une étape de déplétion qui consiste à faire une implantation supplémentaire sur son canal avec du dopant P réduisant ainsi le nombre de porteurs N initialement présent au niveau de son canal et abaissant ainsi sa tension de seuil.

Selon un autre mode de réalisation, dans lequel la cellule de mémoire est destinée à mémoriser un code unique pour chaque circuit, il n'est pas possible d'utiliser un masque. Cependant, l'étape de déplétion est quand même réalisée mais de manière sélective. Pour réaliser l'implantation de manière sélective, préalablement à l'étape d'implantation du dopant de déplétion, on réalise une couche photosensible que l'on va insoler de manière sélective avec un rayonnement électronique (EBEAM) ou à l'aide d'un laser. La couche photosensible est ensuite développée puis on procède à l'implantation.

L'implantation sélective est faite en cours de fabrication. Les cellules sont programmées de manière définitive et il n'est pas possible de reprogrammer la cellule.

On réalise une déplétion car l'abaissement de la tension de seuil permet de réagir avec une tension plus basse d'alimentation qu'un seuil rehaussé.

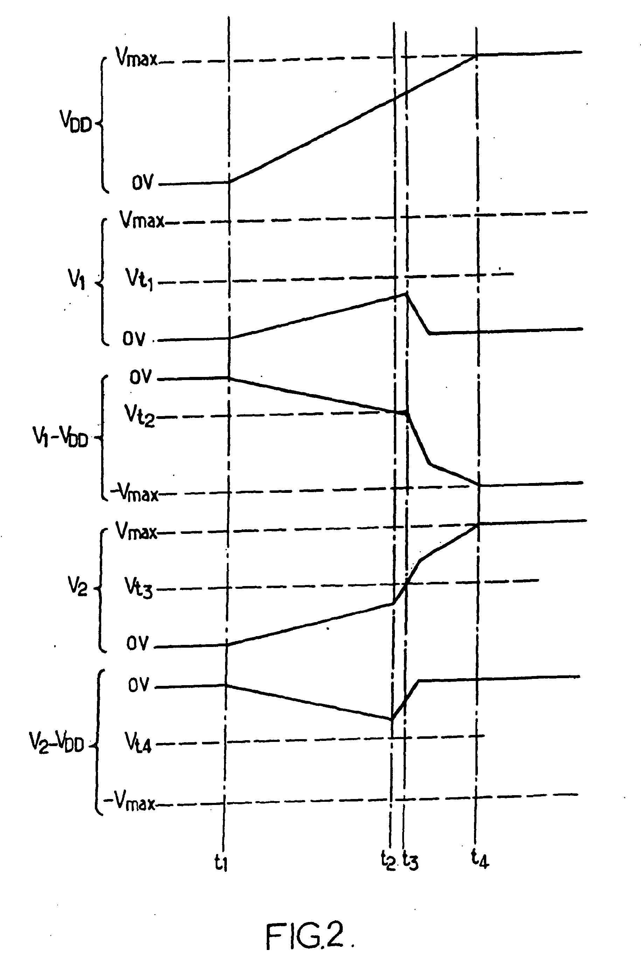

Il va à présent être expliqué comment fonctionne un exemple qui n'est pas selon l'invention correspondant à une cellule de mémoire où tous les transistors sont d'une même taille et/ou le transistor PMOS 24 est déplété. Dans ce mode de réalisation, on considère que la tension d'alimentation est supérieure à deux fois la tension de seuil en valeur absolue d'un transistor quel qu'il soit. La figure 2 représente les chronogrammes des différentes tensions mises en oeuvre.

La tension V_{DD} correspond à la tension d'alimentation de la cellule de mémoire 10. Cette tension d'alimentation est au départ à 0 volts et présente une transition pour arriver à une tension Vₘₐₓ correspondant à la tension d'alimentation. Cette transition est représentée avec une pente accentuée afin de pouvoir mieux expliquer le fonctionnement. La tension V1 représentée sur la figure 2 correspond à la tension de sortie de l'inverseur 21 mais également à la tension grille/source de transistor 25. Sur le chronogramme, il est représenté un niveau de tension V_{T1} qui correspond à la tension de seuil du transistor NMOS 25. Cette tension de seuil 21 est un peu inférieure à la moitié de la tension maximale d'alimentation Vₘₐₓ.

La tension V1 - V_{DD} représentée correspond à la tension grille/source du transistor 24 sur laquelle est représentée la tension de seuil V_{T2} qui se trouve bien inférieure à la moitié de la tension maximale d'alimentation car ce transistor est déplété. Il est à noter que cette tension est négative car il s'agit d'un transistor PMOS.

La tension V2 correspond à la tension de sortie de l'inverseur 20 et à la tension d'entrée de l'inverseur 21. Cette tension V2 correspond également à la tension grille/source du transistor 27, la tension V_{T3} correspondant à sa tension de seuil.

La tension V1- V_{DD} correspond à la tension grille/source du transistor 26 sur lequel on a représenté la tension de seuil V_{T4} correspondant audit transistor 26.

Comme indiqué précédemment, les tensions V_{T1}, V_{T3} et V_{T4} en valeurs absolues sont pratiquement égales. De manière rigoureuse, la tension V_{T4} est en valeur absolue légèrement supérieure aux tensions V_{T1} et V_{T3}. Par contre, la tension V_{T2} se trouve être très inférieure, en valeur absolue, à toutes les autres tensions de seuil V_{T1}, V_{T3} et V_{T4}.

Comme indiqué précédemment, il s'agit d'une cellule de mémoire standard où les transistors sont de la même taille. Lors de la mise sous tension, la cellule de mémoire est dans un état non déterminé, tous les transistors étant bloqués. La tension d'entrée de chacun des inverseurs correspond à une tension définie par un pont capacitif diviseur de tension qui correspond aux capacités équivalentes entre grille et substrat des transistors formant la cellule. Les transistors 24 à 27 ayant les mêmes dimensions en terme de longueur et largeur de canal, le pont capacitif formé par chaque inverseur permet d'avoir une tension de grille égale à la moitié de la tension d'alimentation tant qu'aucun transistor n'a été rendu passant. Ainsi, lorsque à l'instant t1, la tension d'alimentation V_{DD} se met à croître en pente douce, les tensions V1 et V2 se mettent à croître mais avec une pente divisée par deux par rapport à la pente de la tension d'alimentation V_{DD} et, réciproquement, les tensions V1 - V_{DD} et V2 - V_{DD} décroissent avec une pente deux fois inférieure à la pente de la tension d'alimentation V_{DD}. A un instant t2, la tension V1 - V_{DD} atteint la tension de seuil V_{T2} du transistor 24. Le transistor 24 devient alors passant et la tension V2 se met à rejoindre rapidement la tension d'alimentation V_{DD}. La commutation du transistor 24 provoque une pente plus rapide que la pente de croissance de la tension d'alimentation et, à un instant t3, la tension V2 atteint la tension de seuil V_{T3} du transistor 27. Ce transistor 27 se met alors à conduire et ramène la tension V1 à la tension de masse (0 volts).

La conduction du transistor 24 ramenant la tension V2 à la tension d'alimentation ramène également la tension V2 - V_{DD} à une tension nulle. Ainsi, le transistor 26 reste toujours bloqué. La conduction du transistor 27 provoque le retour à zéro de la tension V1 et maintient ainsi le transistor 25 bloqué. Cette évolution de la tension V1 ramène la tension V1 - V_{DD} à une tension proche de la tension V_{DD} qui maintient le transistor 24 passant. La tension V_{DD} continue de s'installer jusqu'à arriver à une tension Vₘₐₓ et la cellule se trouve positionnée dans un état prédéfini par la déplétion du transistor 24.

Il est à noter que le niveau 0 ou 1 d'une cellule est défini de manière arbitraire suivant que l'on décide que le niveau 1 corresponde à une tension haute pour V1 et à une tension basse pour V2 ou l'inverse. La programmation d'une cellule va consister dans l'exemple décrit à dépléter soit le transistor 24 soit le transistor 26 suivant l'état 0 ou 1 que l'on désire pré-enregistrer.

Il est à noter que l'exemple considère un transistor PMOS déplété pour la cellule mais un transistor NMOS aurait pu être déplété à la place. De même, on aurait également pu considérer que plutôt qu'une déplétion, ce soit un enrichissement. De manière extrême, on aurait pu agir sur les seuils des quatre transistors de la cellule, un inverseur ayant un transistor PMOS déplété et un transistor NMOS enrichi, et l'autre inverseur ayant un transistor PMOS enrichi et un transistor NMOS déplété. Cependant, pour réduire les coûts de fabrication, il est préférable de n'utiliser qu'une seule des deux techniques (déplétion ou enrichissement). Egalement, pour avoir un fonctionnement sensiblement le même qu'une cellule SRAM conventionnelle, il est préférable de ne toucher qu'à un seul inverseur.

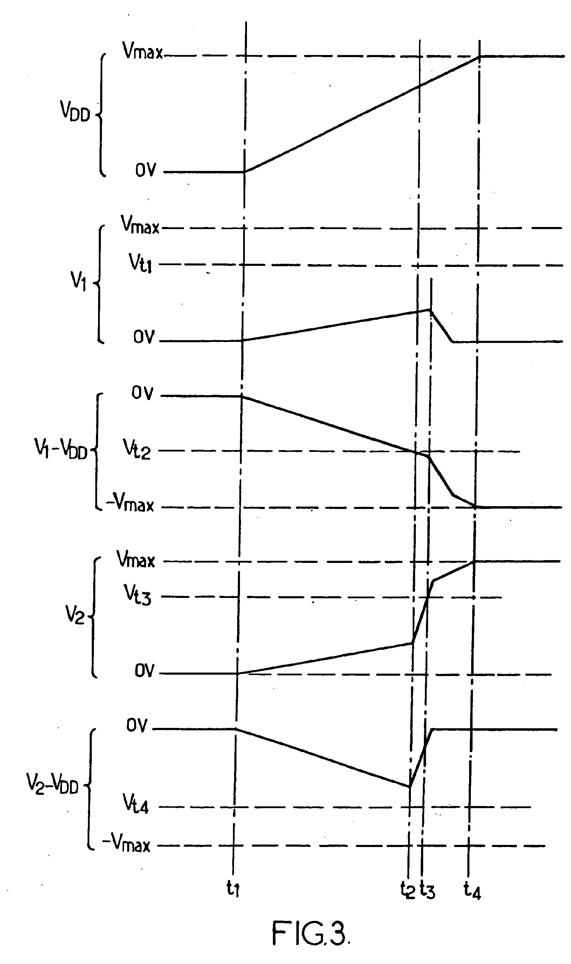

Dans l'exemple qui vient d'être décrit, on a considéré que la tension maximale Vₘₐₓ d'alimentation était au moins deux fois supérieure à une tension de seuil en valeur absolue. A l'heure actuelle, la technologie évolue pour utiliser des tensions d'alimentation de plus en plus basses. Cette évolution de la technologie fait que les tensions de seuil des transistors ont tendance à être supérieures en valeur absolue à la moitié de la tension d'alimentation. Dans un tel cas, il faut avoir recours à une forte déplétion pour obtenir l'effet désiré. Cependant, selon un mode de réalisation, on peut éviter d'avoir recours à une déplétion trop importante, on peut avoir recours à un dimensionnement des surfaces de grille différent entre les transistors NMOS et les transistors PMOS. A titre d'exemple, un surdimensionnement des capacités de grilles des transistors opposés au transistor déplété permet d'atteindre plus rapidement la tension de seuil du transistor déplété. La figure 3, correspond à un mode de réalisation où les tensions de seuil V_{T1}, V_{T3} et V_{T4} sont en valeurs absolues, par exemple égales à deux tiers de la tension maximale d'alimentation Vₘₐₓ. Le transistor 24 est toujours un transistor déplété mais avec une tension de seuil ramenée, par exemple, à environ Vₘₐₓ/2. Pour être sûr d'arriver à cette tension de seuil V_{T2}, les transistors NMOS 25 et 27 ont des dimensions par rapport aux transistors PMOS 24 et 26, en terme de surface de grille, telles que le rapport capacitif créé par le pont de capacités de grille équivalentes entre le transistor PMOS et le transistor NMOS de chaque inverseur provoque lors de la mise sous tension un pont diviseur de tension qui ramène la tension d'entrée V1 ou V2 de chacun des inverseurs 20 et 21 à une tension égale à un tiers de la tension d'alimentation V_{DD}.

Ainsi, les tensions V1 et V2 évoluent avec une pente égale à un tiers de la pente de la tension V_{DD} tant que celles-ci ne seront pas pilotées par la conduction de l'un des transistors 24 à 27. Inversement, les tensions grille/source des transistors PMOS 24 et 25 évoluent avec une pente égale à deux tiers de la pente de la tension V_{DD}. Ainsi, la tension V1 - V_{DD} peut arriver à un instant t2 à une tension égale à la tension V_{T2}, bien que celle-ci soit égale à la moitié de la tension de seuil, et provoquer le même phénomène de conductions successives du transistor 24 puis du transistor 27.

Il est à noter que, même s'il n'est pas possible d'atteindre la tension de seuil des transistors lors de la mise sous tension, le positionnement de la cellule 10 dans le niveau souhaité est réalisé. A titre d'exemple, si les transistors ont la même surface de grille avec des tensions de seuil supérieures à la moitié de la tension maximale V_{MAX} d'alimentation, ceux-ci vont rester dans un état bloqué après l'établissement de la tension d'alimentation. Cependant, même à l'état bloqué, les transistors laissent passer un courant de fuite. Les grilles d'un inverseur sont alors chargées ou déchargées par la différence des courants de fuite existant entre le transistor NMOS et le transistor PMOS de l'autre inverseur. Dans le cas où les inverseurs sont asymétriques, celui qui aura une tension de seuil éloignée de V_{MAX}/2 fera évoluer la tension de grille de l'autre inverseur qui se trouvera alors déséquilibré et amplifiera le basculement en conséquence.

Un avantage d'une telle cellule 10 est également de permettre à un circuit d'avoir une identification furtive. En effet, il n'est possible d'accéder à une information non volatile qu'après la mise sous tension et avant d'effectuer une écriture de celle-ci. On peut donc effacer le contenu non volatil après l'avoir utilisé tout en le conservant de manière cachée.

Le caractère furtif peut être augmenté dans certains cas en coupant l'alimentation des cellules. Une telle utilisation permet à un circuit de mémoriser un numéro d'identification secret et de ne pouvoir y accéder que si l'on alimente les cellules pour le lire. L'alimentation des cellules peut alors être conditionnelle, ce qui renforce le caractère confidentiel de leur contenu. A cet effet, on peut prévoir des moyens de commande pour mettre sous tension ou hors tension le circuit d'alimentation qui alimente les cellules de mémoire uniquement pour lire le contenu desdites cellules.

De plus, si une personne malintentionnée désire obtenir les informations non volatiles des cellules par une technique d'ingénierie inversée, il lui est nécessaire d'effectuer une analyse de dopage de tous les transistors de mémorisation, ce qui est très complexe à réaliser. Pour compliquer l'analyse par ingénierie inversée, les cellules de mémoire peuvent être dispersées parmi les circuits logiques constituant le circuit intégré où elles sont placées.

## Revendications

1. Cellule de mémoire (10) comportant deux inverseurs (20, 21) montés tête-bêche pour mémoriser un bit, chaque inverseur comportant un transistor (24 ou 26) d'un premier type et un transistor (25 ou 27) d'un second type, la concentration de porteurs dans le canal de conduction du transistor (24) du premier type de l'un des inverseurs (20) étant différente de la concentration de porteurs dans le canal de conduction du transistor (26) du premier type de l'autre des inverseurs (21), **caractérisé en ce que** le transistor (24) du premier type d'un seul des inverseurs est un transistor déplété de sorte que les inverseurs aient des tensions de seuil différentes, et **en ce que** dans les transistors (25, 27) du deuxième type ont une surface de grille différente par rapport à la surface de grille des transistors (24, 26) du premier type et les capacités de grille des transistors du deuxième type sont surdimensionnées par rapport aux capacités de grille des transistors du premier type.

2. Cellule de mémoire selon la revendication 1, dans laquelle les transistors (24, 26) du premier type sont des transistors PMOS, dans laquelle les transistors (25, 27) du deuxième type sont des transistors NMOS.

3. Circuit intégré comportant des cellules selon l'une des revendications 1 et 2, et un circuit (11) apte à fournir une tension d'alimentation en pente douce desdites cellules lors de la mise sous tension.

4. Circuit intégré selon la revendication 3, comportant en outre des moyens de commande pour mettre sous tension ou hors tension le circuit d'alimentation qui alimente lesdites cellules, ledit circuit de commande étant apte à mettre le circuit d'alimentation sous tension uniquement pour lire le contenu desdites cellules.

5. Circuit intégré selon l'une quelconque des revendications 3 et 4, dans lequel les cellules sont dispersées parmi les circuits logiques constituant le circuit intégré.

6. Circuit de mémoire électronique réalisé sur une puce de semi-conducteur, ledit circuit comportant une pluralité de cellules élémentaires de mémorisation, chaque cellule élémentaire pouvant mémoriser un bit à l'aide de deux inverseurs montés tête-bêche, **caractérisé en ce qu'**il comporte en outre au moins une cellule (10) selon la revendication 1.

7. Circuit de mémoire selonla revendication 6, dans laquelle les transistors du premier type sont des transistors PMOS, et dans laquelle les transistors du deuxième type sont des transistors NMOS.

## Claims

1. Memory cell (10) comprising two inverters (20, 21) configured as a flip-flop for storing one bit, each inverter comprising a transistor (24 or 26) of a first type and a transistor (25 or 27) of a second type, wherein the concentration of carriers in the conduction channel of the transistor (24) of the first type of one of the inverters (20) is different from the concentration of carriers in the conduction channel of the transistor (26) of the first type of the other inverter (21) **characterized in that** the transistors (24) of the first type of only one of the inverters is a depleted transistor so that the inverters have different threshold voltages, and **in that** the transistors (25, 27) of the second type have a channel surface area different from the channel surface area of the transistors (24, 26) of the first type and the gate capacitances of the transistors of the second type are oversized compared to the gate capacitances of the transistors of the first type.

2. Memory cell according to Claim 1, wherein the transistors (24, 26) of the first type are p-MOS transistors, and wherein the transistors (25, 27) of the second type are n-MOS transistors.

3. Integrated circuit comprising cells according to one of Claims 1 and 2, and a circuit (11) capable of delivering a 'soft-start' power supply voltage for said cells at power up.

4. Integrated circuit according to Claim 3, further comprising control means for turning on or off the power supply circuit that supplies the cells, said control circuit being capable of only turning on the power supply circuit for reading the contents of said cells.

5. Integrated circuit according to either of Claims 3 and 4, wherein the cells are dispersed amongst the logic circuits forming the integrated circuit.

6. Electronic memory circuit fabricated on a semiconductor chip, said circuit comprising a plurality of elementary storage cells, each elementary cell being able to store one bit by means of two inverters configured as a flip-flop, **characterized in that** it further comprises at least one cell (10) according to claim 1.

7. Memory circuit according to Claim 6, wherein the transistors of the first type are p-MOS transistors, and wherein the transistors of the second type are n-MOS transistors.

## Patentansprüche

1. Speicherzelle (10), umfassend zwei Inverter (20, 21), die entgegengesetzt angebracht sind, um ein Bit zu speichern, wobei jeder Inverter einen Transistor (24 oder 26) von einem ersten Typ und einen Transistor (25 oder 27) von einem zweiten Typ umfasst, wobei die Ladungsträger-Konzentration im Leitungskanal des Transistors (24) vom ersten Typ des einen der Inverter (20) verschieden von der Ladungsträger-Konzentration im Leitungskanal des Transistors (26) vom ersten Typ des anderen der Inverter (21) ist,
**dadurch gekennzeichnet, dass** der Transistor (24) vom ersten Typ von einem einzigen der Inverter ein Verarmungstransistor ist, so dass die Inverter unterschiedliche Schwellenspannungen haben, und dadurch, dass die Transistoren (25, 27) vom zweiten Typ eine in Bezug auf die Gate-Fläche der Transistoren (24, 26) vom ersten Typ verschiedene Gate-Fläche aufweisen, und dass die Gate-Kapazitäten der Transistoren vom zweiten Typ in Bezug auf die Gate-Kapazitäten der Transistoren vom ersten Typ überdimensioniert sind.

2. Speicherzelle nach Anspruch 1, wobei die Transistoren (24, 26) vom ersten Typ PMOS-Transistoren sind, und wobei die Transistoren (25, 27) vom zweiten Typ NMOS-Transistoren sind.

3. Integrierter Schaltkreis, umfassend Zellen nach einem der Ansprüche 1 und 2 und einen Schaltkreis (11), der dazu geeignet ist, den Zellen beim Anlegen von Spannung eine Versorgungsspannung mit einem sanften Gefälle zu liefern.

4. Integrierter Schaltkreis nach Anspruch 3, umfassend weiter Steuer-/Regel-Mittel, um an den Versorgungs-Schaltkreis, der die Zellen versorgt, eine Spannung anzulegen oder ihn von der Spannung zu trennen, wobei der Steuer-/Regel-Schaltkreis dazu geeignet ist, an den Versorgungs-Schaltkreis eine Spannung anzulegen, nur um den Inhalt der Zellen auszulesen.

5. Integrierter Schaltkreis nach einem der Ansprüche 3 und 4, wobei die Zellen unter den Logik-Schaltkreisen, die den integrierten Schaltkreis bilden, verteilt sind.

6. Elektronischer Speicher-Schaltkreis, verwirklicht auf einem Halbleiter-Chip, wobei der Schaltkreis eine Mehrzahl von elementaren Zellen zur Speicherung umfasst, wobei jede elementare Zelle ein Bit mittels zwei entgegengesetzt angebrachten Inverter speichern kann, **dadurch gekennzeichnet, dass** er weiter wenigstens eine Zelle (10) nach Anspruch 1 umfasst.

7. Speicher-Schaltkreis nach Anspruch 6, wobei die Transistoren vom ersten Typ PMOS-Transistoren sind und wobei die Transistoren vom zweiten Typ NMOS-Transistoren sind.
